# EUROPEAN PATENT SPECIFICATION

(11) **EP 3 989 524 B1**
(45) Date of publication and mention of the grant of the patent: **15.11.2023**
(21) Application number: 20930814.7
(22) Date of filing: 27.11.2020
(51) Int. Cl.: H04M 1/02, H04M 1/18

(54) **FOLDING DISPLAY APPARATUS, MOBILE TERMINAL, AND DISPLAY METHOD**
KLAPPBARES ANZEIGEGERÄT, MOBILES ENDGERÄT UND ANZEIGEVERFAHREN
APPAREIL D'AFFICHAGE PLIABLE, TERMINAL MOBILE, ET PROCÉDÉ D'AFFICHAGE

(30) Priority: 17.04.2020 CN 202010304731
(43) Date of publication of application: 27.04.2022
(73) Proprietor: Shanghai Wingtech Electronics Technology Co., Ltd., Shanghai 200030 (CN)
(72) Inventor: FENG, Wei, Shanghai 200030 (CN)
(74) Representative: Grünecker Patent- und Rechtsanwälte PartG mbB
(86) International application number: PCT/CN2020/132051
(87) International publication number: WO 2021/208448

(56) References cited:
- EP-A1- 3 886 078
- CN-A- 107 424 518
- CN-A- 108 363 455
- CN-A- 109 637 375
- CN-A- 111 327 740
- CN-U- 202 353 628
- CN-U- 206 650 704
- US-A1- 2012 139 815
- US-A1- 2016 026 219
- US-A1- 2016 143 131
- US-A1- 2016 291 642
- US-A1- 2018 188 778

## Description

### TECHNICAL FIELD

The present application relates to the technical field of electronic apparatuses, and more particularly, to a foldable display device, a mobile terminal and a display method.

### BACKGROUND

Mobile terminals with foldable screens have begun to appear, and major manufacturers have launched their own products.

US 20180188778A1 discloses a foldable display device, comprising: a flexible screen, wherein the flexible screen is configured for displaying an object, and comprises a first part and a second part, and a bendable third part between the first part and the second part; and a housing, wherein the housing comprises a front side of the housing, and the first part is slidably supported on the front side of the housing; and the housing further comprises a holding tank extending in parallel with the front side of the housing, and the second part is slidable into the holding tank, when the third part is not bent. US 20180188778A1 further discloses a method, using the above-mentioned foldable display device, comprising the steps of: controlling display according to the state of the housings by the controller.

US 20160026219A1 discloses a flexible display unit comprising a first part, a second part rotatable based on a first boundary portion of the first part, and a third part rotatable based on a second boundary portion of the first part. Both the second and third parts are configured to cover and not cover the first part without any further protection or guiding portion for the foldable displays. US 20160143131A1 discloses a flexible display comprising a flexible display panel, a guide member fixed to the flexible display panel and a sliding member connected to the housing and the guide member and moving the second flat portion substantially the same distance as the first flat portion when moving, yet in an opposite direction.

US 20160291642A1 discloses a foldable body for an electronic device, wherein a flexible display device is disposed on a front face of the body and is foldable together with the body, and may include an exposed region that remains visible when the foldable body is in the folded state.

EP 3886078A1, late published on 29.09.2021, discloses a flexible display device comprising a flexible display unit arranged on one surface of a first body and a second body and folded and unfolded by the relative rotations between the first and second body by a hinge unit. A covering member covers a space formed between the first and second body in a folded state and a lever connected to the hinge unit to support at least a part of the covering member.

However, from the view of market, foldable flexible screens of current products are all combined with apparatuses, which are relatively thick in overall, giving users a bad experience.

The foldable screen will not display all areas for a long time when in use, so it is necessary to protect the parts that are not frequently displayed.

### SUMMARY

The present application provides a foldable display device, a mobile terminal and a display method, so as to protect a flexible screen part which is not frequently displayed.

The present application provides a foldable display device, including:
a flexible screen, wherein the flexible screen is configured for displaying an object, and includes a first part and a second part, and a bendable third part between the first part and the second part; and
a housing, wherein the housing includes a front side of the housing, and the first part is slidably supported on the front side of the housing; and the housing further includes a holding tank extending in parallel with the front side of the housing;
a sensor configured to detect a state of the third part; and
a controller, wherein the controller is configured to control display of the first part, the second part and the third part according to the state,
wherein the second part is slidable into the holding tank when the third part is bent, and
wherein the sensor is on the third part to detect a state of the third part.

The foldable display device can partially hold the flexible screen into the holding tank, thus avoiding the part from contacting with the outside world so as to protect the part.

Since main deformation of the flexible screen occurs in the third part, setting the sensor in the third part can timely and accurately acquire a bent state of the flexible screen, and acquire the state of the flexible screen through the sensor and control a display area of the flexible screen, thus enriching a display state of the flexible screen.

As an optional solution of the foldable display device above, the sensor is a bending sensor.

As an optional solution of the foldable display device above, the flexible screen is provided with supporting mechanisms, the front side of the housing and the holding tank are provided with guide parts extending in a slide direction, and the supporting mechanisms are slidably connected to the guide parts.

As an optional solution of the foldable display device above, the guide parts are arranged on both sides of the front side of the housing and the holding tank in the slide direction, the supporting mechanisms are arranged on both sides of the flexible screen in the slide direction, and the guide parts are covered on the supporting mechanisms.

The two sides of the flexible screen are provided with the supporting mechanisms and covered by the guide parts, so that a certain dustproof effect can be achieved.

As an optional solution of the foldable display device above, the supporting mechanism is arranged on a non-display surface of the flexible screen, the guide part is one of a rib and a chute, and the supporting mechanism is provided with the other of the rib and the chute.

The present application further provides a mobile terminal, including the foldable display device above.

The present application further provides a display method, using the foldable display device above, including the steps of:
detecting a state of the third part through the sensor; and
respectively controlling display of the first part, the second part and the third part according to the state by the controller.

As an optional solution of the display method above, the state includes a bent state and a flattened state.

As an optional solution of the display method above, the respectively controlling the display of the first part, the second part and the third part according to the state comprises the steps ofa:
when the state is the bent state, controlling the first part and/or the third part to display and controlling the second part not to display; and
when the state is the flattened state, controlling the first part, the second part and the third part to display simultaneously.

The mobile terminal provided by the present application can partially hold the screen into the holding tank, thus avoiding the part from contacting with the outside world so as to protect the part. By obtaining the state of the third part of the flexible screen, the display area of the flexible screen is controlled, thus enriching the display state of the flexible screen.

### BRIEF DESCRIPTION OF THE DRAWINGS

In order to illustrate the technical solutions in the embodiments of the present application more clearly, the accompanying drawings used in the description of the embodiments will be briefly described below. The accompanying drawings in the following description only illustrate some embodiments of the present application. Those having ordinary skills in the art can obtain other drawings according to these drawings.
FIG. 1 is a schematic structural diagram of a mobile terminal in a storage state according to an embodiment of the present application;
FIG. 2 is a schematic structural diagram of a mobile terminal in an unfolded process according to the embodiment of the present application;
FIG. 3 is a schematic structural diagram of another mobile terminal in an unfolded process according to an embodiment of the present application;
FIG. 4 is a schematic structural diagram of yet another mobile terminal in an unfolded process according to an embodiment of the present application;
FIG. 5 is a schematic structural diagram when a flexible screen and a housing of a mobile terminal according to an embodiment of the present application are matched; and
FIG. 6 is a schematic structural diagram when a flexible screen and a housing of a mobile terminal according to another embodiment of the present application are matched.

In the drawings:
1 refers to housing; 2 refers to flexible screen; 3 refers to sensor; 1A refers to front side of housing; 1B refers to back side of housing; 1C refers to holding tank; 10 refers to guide part; 20 refers to supporting mechanism, 21 refers to first part; 22 refers to second part; and 23 refers to third part.

### DETAILED DESCRIPTION

The present application is described below with reference to the accompanying drawings and the embodiments. The embodiments described herein are merely illustrative of the present application and are not intended to limit the scope of the invention as defined in the appended claims. For ease of description, the accompanying drawings only show a part of the structure related to the present application, but not all of the structure.

In the description of the present invention, unless expressly stipulated and defined otherwise, terms such as "connected", "connection", and "fixing" should be understood broadly, for example, the connection may be fixed connection, detachable connection or integrated connection; may be mechanical connection, and may also be electrical connection; and may be direct connection, may also be indirect connection through an intermediate medium, and may also be internal communication of two elements or interaction relationship of two elements. For those having ordinary skills in the art, the meaning of the above-mentioned terms in the application can be understood according to specific situations.

In the present invention, unless expressly stipulated and defined otherwise, the first feature "over" or "under" the second feature may include that the first and second features are in direct contact, and may also include that the first and second features are not directly contacted, but contacted through other intermediate features. Moreover, the first feature "over", "above" and " upper" the second feature includes that the first feature is right above or diagonally above the second feature, or simply means that a horizontal height of the first feature is higher than that of the second feature. The first feature "under", "below" and "lower" the second feature includes that the first feature is right below or diagonally below the second feature, or only means that the horizontal height of the first feature is less than that of the second feature.

In the description of the embodiments, the orientation or positional relationship indicated by the terms "upper", "lower", "right" and the like is based on the orientation or positional relationship shown in the drawings, only for the convenience of describing and simplifying the operations, and does not indicate or imply that the indicated device or element must have a specific orientation, or be constructed and operated in a specific orientation. Therefore, the terms should not be construed as limiting the present application. Moreover, the terms "first" and "second" are only used to distinguish between descriptions and have no special meaning.

The present application provides a foldable display device.

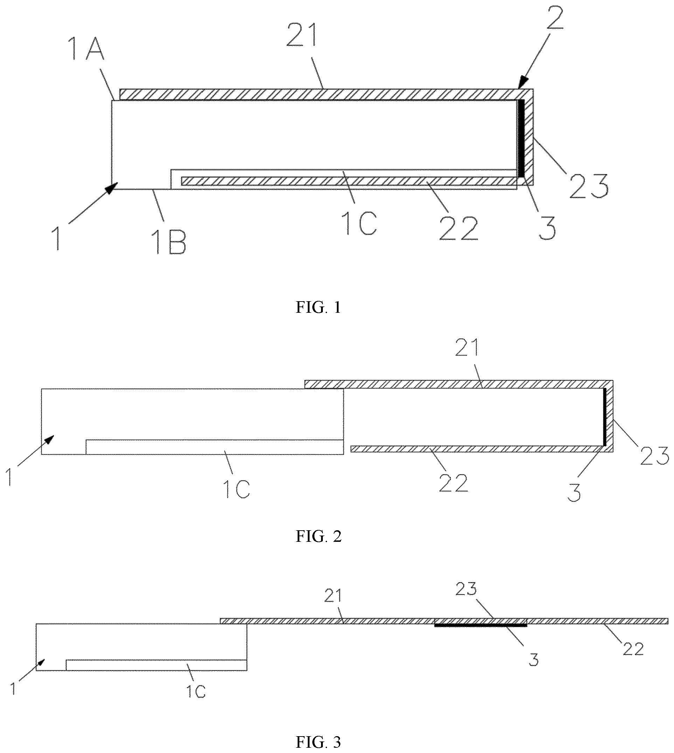

As shown in FIG. 1 to FIG. 4, the foldable display device includes a housing 1 and a flexible screen 2. The housing 1 is provided with a front side 1A of the housing and a back side 1B of the housing, and a holding tank 1C is provided between the front side 1A of the housing and the back side 1B of the housing. The holding tank 1C is parallel to the front side 1A of the housing. The flexible screen 2 is configured for displaying an object, and the flexible screen 2 includes a first part, a second part and a bendable third part 23 between the first part 21 and the second part 22. The first part 21 is slidably supported on the front side 1A of the housing. The third part 23 is connected between the first part 21 and the second part 22. When the third part 23 is bent, the second part 22 is capable of sliding into the holding tank 1C.

It should be noted that in this embodiment, the third part 23 is arranged on a right side of the foldable display device, that is, the flexible screen 2 can slide from left to right.

The third part 23 may also be arranged at a bottom of the foldable display device in a length direction. In this case, the flexible screen 2 can slide out from the bottom of the foldable display device in the length direction, but the present application is not limited to this.

As shown in FIG. 1, the first part 21 is arranged on the front side 1A of the housing, and the second part 22 is entirely arranged in the holding tank 1C. As shown in FIG. 2 to FIG. 4, the third part 23 and the second part 22 gradually slide to the right, and the second part 22 is driven to protrude out from the holding tank 1C. Finally, the second part 22, the third part 23 and the first part 21 are on the same plane.

It should be noted that a length of the first part 21 is greater than a length of the second part 22, so that when the first part 21 slides to a tail end, the second part 22 is fully extended protruded out from the holding tank 1C. In this embodiment, the length of the first part 21 corresponds to a length of the front side 1A of the housing, while the length of the second part 22 is 4/5 of the length of the first part 21.

The mobile terminal further includes a sensor 3 and a controller. The sensor 3 is on the third part 23 to obtain a state of the third part 23, and the controller controls display of the first part 21, the second part 22 and the third part 23 according to the state.

In this embodiment, the sensor 3 is a bending sensor.

When the sensor 3 determines that the third part 23 is in a bent state, a display state of the foldable display device may be set as follows: in a first case, contents are displayed on the first part 21 only; in a second case, contents are displayed on the third part 23 only; and in a third case, contents are simultaneously displayed on the first part 21 and the third part 23. In other words, when the third part 23 is in the bent state, contents are not displayed on the second part 22 in the holding tank 1C.

When the sensor 3 determines that the foldable display device is in a flattened state, the display state of the foldable display device may be set as follows: contents are simultaneously displayed on the first part 21, the third part 23 and the second part 22.

It should be noted that although the second part 22 may not be coplanar with the first part 21, due to a factor of display effects, a user is allowed to continuously bend the third part 23, so that the first part 21 and the second part 22 are on the same horizontal plane, that is, an included angle between the first part and the second part is 180 degrees.

In this embodiment, the bent state means that the third part 23 makes the included angle between the first part 21 and the second part 22 range from 0 degree to 170 degrees, and the flattened state means that the third part 23 makes the included angle between the first part 21 and the second part 22 range from 0 degree to 180 degrees.

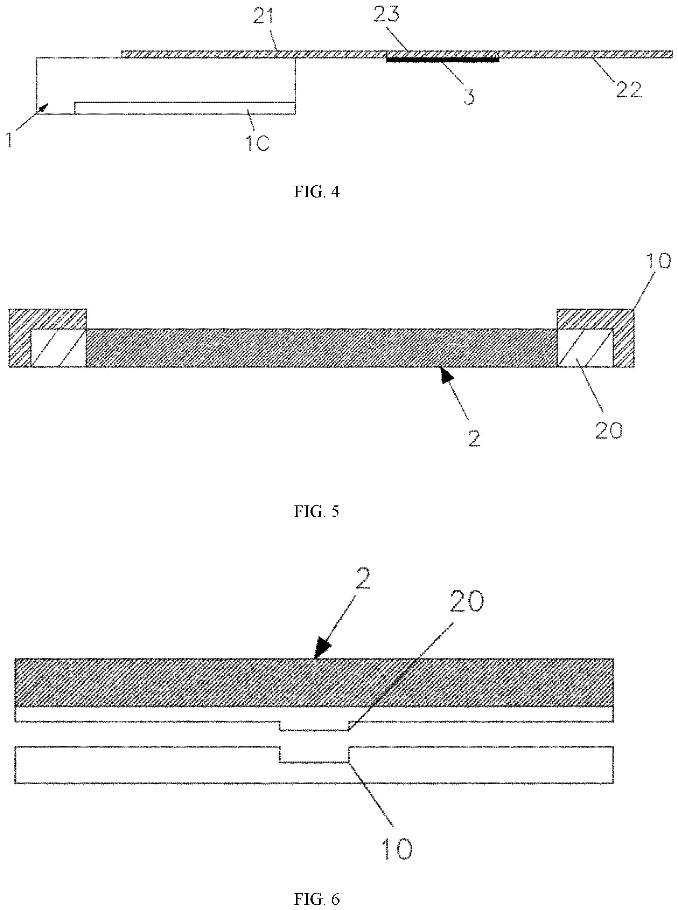

As shown in FIG. 5 and FIG. 6, the flexible screen 2 is provided with supporting mechanisms 20. The supporting mechanisms 20 improve strength of the flexible screen 2. The front side 1A of the housing and the holding tank 1C are provided with guide parts 10 extending in a slide direction, and the supporting mechanisms 20 are slidably connected to the guide parts 10.

It should be noted that the flexible screen 2 further includes a retaining mechanism (not shown in the figure) that can keep at any angle when the retaining mechanism bends. In this embodiment, the retaining mechanism is arranged in the third part 23 of the flexible screen 2, and a damping hinge is employed as the retaining mechanism.

With reference to FIG. 1 to FIG. 5, the guide parts 10 are arranged on both sides of the front side 1A of the housing and the holding tank 1C in the slide direction, and the supporting mechanisms 20 are arranged on both sides of the flexible screen 2 in the slide direction, and the guide parts 10 are covered on the supporting mechanisms 20. Both sides of the flexible screen 2 are always arranged in the guide parts 10, thereby improving a dustproof effect of the foldable display device.

With reference to FIG. 1 to FIG. 4 and FIG. 6, in another embodiment, the supporting mechanism 20 is arranged on a non-display surface of the flexible screen, the guide part 10 is one of a rib and a chute, and the supporting mechanism 20 is provided with the other of the rib and the chute. In this embodiment, the guide part 10 is a groove, and the supporting mechanism 20 is provided with a rib.

Compared with the embodiment of FIG. 5, the flexible screen 2 shown in FIG. 6 has no blocking edges, which maximizes the display area of the flexible screen 2.

It should be noted that the flexible screen 2 can be slided by software, for example, may be controlled by virtual keys displayed on the flexible screen 2, or may be slided manually.

The present application further provides a mobile terminal, and the mobile terminal is provided with the foldable display device above.

The present application further provides a display method, using the foldable display device above, including the steps of:
detecting a state of the third part 23; and
respectively controlling display of the first part 21, the second part 22 and the third part 23 according to the state.

It should be noted that the state includes the bent state and the flattened state above.

A working principle of the mobile terminal of the present application is as follows:
In the bent state as shown in FIG.1, the flexible screen 2 presents a U-shaped structure, the first part 21 is arranged on the front side 1A of the housing, and the second part 22 is held in the holding tank 1C. The sensor 3 detects that the third part 23 is in the bent state, and only controls the first part 21 and/or the third part 23 to display, and controls the second part 22 not to display. As shown in FIG. 2, the first part 21 is slided to make the second part 22 slide out of the holding tank 1C, then the third part 23 is continuosly bent, so that the second part 22, the third part 23 and the first part 21 are on the same plane (the flattened state shown in FIG. 3). When the sensor 3 detects that the third part 23 is in the flattened state, the first part 21, the third part 23 and the second part 22 are controlled to display contents simultaneously. Finally, the first part 21 is slided to the home position as shown in FIG. 4 to achieve the best use effect.

## Claims

1. A foldable display device, comprising:
a flexible screen (2), wherein the flexible screen (2) is configured for displaying an object, and comprises a first part (21) and a second part (22), and a bendable third part (23) between the first part (21) and the second part (22);
a housing (1), wherein the housing (1) comprises a front side (1A) of the housing, and the first part (21) is slidably supported on the front side (1A) of the housing; and the housing (1) further comprises a holding tank (1C) extending in parallel with the front side (1A) of the housing;
a sensor (3) configured to detect a state of the third part; and
a controller, wherein the controller is configured to control display of the first part (21), the second part (22) and the third part (23) according to the state,
**characterized in that**
the second part (22) is slidable into the holding tank (1C) when the third part (23) is bent,
wherein the sensor (3) is provided on the third part (23).

2. The foldable display device according to claim 1, **characterized in that** the sensor (3) is a bending sensor.

3. The foldable display device according to claim 1 or 2, **characterized in that** the flexible screen (2) is provided with supporting mechanisms (20), the front side (1A) of the housing and the holding tank (1C) are provided with guide parts (10) extending in a slide direction, and the supporting mechanisms (20) are slidably connected to the guide parts (10).

4. The foldable display device according to claim 3, **characterized in that** the guide parts (10) are arranged on both sides of the front side (1A) of the housing and the holding tank (1C) in the slide direction, the supporting mechanisms (20) are arranged on both sides of the flexible screen (2) in the slide direction, and the guide parts (10) are covered on the supporting mechanisms (20).

5. The foldable display device according to claim 3, **characterized in that** the supporting mechanism (20) is arranged on a non-display surface of the flexible screen (2), the guide part (10) is one of a rib and a chute, and the supporting mechanism (20) is provided with the other of the rib and the chute.

6. A mobile terminal, comprising the foldable display device according to any one of claims 1 to 5.

7. A display method, using the foldable display device according to any one of claims 1 to 5, comprising the steps of:
detecting a state of the third part through the sensor (3); and
respectively controlling display of the first part (21), the second part (22) and the third part (23) according to the state by the controller.

8. The display method according to claim 7, **characterized in that** the state comprises a bent state and a flattened state.

9. The display method according to claim 8, **characterized in that** the respectively controlling the display of the first part (21), the second part (22) and the third part (23) according to the state comprises the steps of:
when the state is the bent state, controlling the first part (21) and/or the third part (23) to display and controlling the second part (22) not to display; and
when the state is the flattened state, controlling the first part (21), the second part (22) and the third part (23) to display simultaneously.

## Patentansprüche

1. Faltbare Anzeigevorrichtung, umfassend:
einen flexiblen Bildschirm (2), wobei der flexible Bildschirm (2) zum Anzeigen eines Objekts eingerichtet ist und einen ersten Teil (21) sowie einen zweiten Teil (22) und einen biegsamen dritten Teil (23) zwischen dem ersten Teil (21) und dem zweiten Teil (22) umfasst;
ein Gehäuse (1), wobei das Gehäuse (1) eine Vorderseite (1A) des Gehäuses aufweist und der erste Teil (21) verschiebbar auf der Vorderseite (1A) des Gehäuses gelagert ist; und das Gehäuse (1) zudem einen Aufnahmebehälter (1C) aufweist, der sich parallel zu der Vorderseite (1A) des Gehäuses erstreckt;
einen Sensor (3), der derart eingerichtet ist, dass er einen Zustand des dritten Teils erfasst; und
eine Steuereinheit, wobei die Steuereinheit derart eingerichtet ist, dass sie die Anzeige des ersten Teils (21), des zweiten Teils (22) und des dritten Teils (23) gemäß dem Zustand steuert,
**dadurch gekennzeichnet, dass**
der zweite Teil (22) in den Aufnahmebehälter (1C) eingeschoben werden kann, wenn der dritte Teil (23) gebogen ist, wobei der Sensor (3) an dem dritten Teil (23) vorgesehen ist.

2. Faltbare Anzeigevorrichtung nach Anspruch 1, **dadurch gekennzeichnet, dass** der Sensor (3) ein Biegesensor ist.

3. Faltbare Anzeigevorrichtung nach Anspruch 1 oder 2, **dadurch gekennzeichnet, dass** der flexible Bildschirm (2) mit Trägermechanismen (20) versehen ist, die Vorderseite (1A) des Gehäuses und der Aufnahmebehälter (1C) mit Führungsteilen (10) versehen sind, die sich in einer Gleitrichtung erstrecken, und die Trägermechanismen (20) mit den Führungsteilen (10) gleitend verbunden sind.

4. Faltbare Anzeigevorrichtung nach Anspruch 3, **dadurch gekennzeichnet, dass** die Führungsteile (10) auf beiden Seiten der Vorderseite (1A) des Gehäuses und des Aufnahmebehälters (1C) in Gleitrichtung angeordnet sind, die Trägermechanismen (20) auf beiden Seiten des flexiblen Bildschirms (2) in Gleitrichtung angeordnet sind, und die Führungsteile (10) auf den Trägermechanismen (20) abgedeckt sind.

5. Faltbare Anzeigevorrichtung nach Anspruch 3, **dadurch gekennzeichnet, dass** der Trägermechanismus (20) auf einer Nicht-Anzeigefläche des flexiblen Bildschirms (2) angeordnet ist, der Führungsteil (10) entweder eine Rippe oder eine Rille ist und der Trägermechanismus (20) mit der anderen von Rippe und Rille versehen ist.

6. Mobiles Endgerät, das die faltbare Anzeigevorrichtung nach einem der Ansprüche 1 bis 5 umfasst.

7. Anzeigeverfahren unter Verwendung der faltbaren Anzeigevorrichtung nach einem der Ansprüche 1 bis 5, umfassend folgende Schritte:
Erfassen eines Zustands des dritten Teils durch den Sensor (3); und
Steuern jeweils der Anzeige des ersten Teils (21), des zweiten Teils (22) und des dritten Teils (23) gemäß dem Zustand durch die Steuereinheit.

8. Anzeigeverfahren nach Anspruch 7, **dadurch gekennzeichnet, dass** der Zustand einen gebogenen Zustand und einen abgeflachten Zustand umfasst.

9. Anzeigeverfahren nach Anspruch 8, **dadurch gekennzeichnet, dass** das jeweilige Steuern der Anzeige des ersten Teils (21), des zweiten Teils (22) und des dritten Teils (23) gemäß dem Zustand die folgenden Schritte umfasst:
wenn der Zustand der gebogene Zustand ist, Steuern des ersten Teils (21) und/oder des dritten Teils (23) um anzuzeigen, und Steuern des zweiten Teils (22), um nicht anzuzeigen; und,
sofern der Zustand der abgeflachte Zustand ist, Steuern des ersten Teils (21), des zweiten Teils (22) und des dritten Teils (23), um gleichzeitig anzuzeigen.

## Revendications

1. Dispositif d'affichage pliable, comprenant :
un écran flexible (2), dans lequel l'écran flexible (2) est configuré pour afficher un objet et comprend une première partie (21) et une deuxième partie (22), et une troisième partie (23) pliable entre la première partie (21) et la deuxième partie (22) ;
un boîtier (1), dans lequel le boîtier (1) comprend un côté avant (1A) du boîtier, et la première partie (21) est supportée de manière coulissante sur le côté avant (1A) du boîtier ; et le boîtier (1) comprend en outre un réservoir de maintien (10) s'étendant parallèlement au côté avant (1A) du boîtier ;
un capteur (3) configuré pour détecter un état de la troisième partie ; et
un dispositif de commande, dans lequel le dispositif de commande est configuré pour commander l'affichage de la première partie (21), de la deuxième partie (22) et de la troisième partie (23) en fonction de l'état,
**caractérisé en ce que**
la deuxième partie (22) peut coulisser dans le réservoir de maintien (10) lorsque la troisième partie (23) est pliée,
dans lequel le capteur (3) est prévu sur la troisième partie (23).

2. Dispositif d'affichage pliable selon la revendication 1, **caractérisé en ce que** le capteur (3) est un capteur de flexion.

3. Dispositif d'affichage pliable selon la revendication 1 ou 2, **caractérisé en ce que** l'écran flexible (2) est muni de mécanismes de support (20), le côté avant (1A) du boîtier et le réservoir de maintien (10) sont munis de parties de guidage (10) s'étendant dans une direction de coulissement, et les mécanismes de support (20) sont reliés de manière coulissante aux parties de guidage (10).

4. Dispositif d'affichage pliable selon la revendication 3, **caractérisé en ce que** les parties de guidage (10) sont agencées des deux côtés du côté avant (1A) du boîtier et du réservoir de maintien (10) dans la direction de coulissement, les mécanismes de support (20) sont agencés des deux côtés de l'écran flexible (2) dans la direction de coulissement, et les parties de guidage (10) recouvrent les mécanismes de support (20).

5. Dispositif d'affichage pliable selon la revendication 3, **caractérisé en ce que** le mécanisme de support (20) est agencé sur une surface de non affichage de l'écran flexible (2), la partie de guidage (10) est l'une d'une nervure et d'une goulotte, et le mécanisme de support (20) est muni de l'autre de la nervure et de la goulotte.

6. Terminal mobile, comprenant le dispositif d'affichage pliable selon l'une quelconque des revendications 1 à 5.

7. Procédé d'affichage, utilisant le dispositif d'affichage pliable selon l'une quelconque des revendications 1 à 5, comprenant les étapes consistant à :
détecter un état de la troisième partie par l'intermédiaire du capteur (3) ; et
commander respectivement l'affichage de la première partie (21), de la deuxième partie (22) et de la troisième partie (23) en fonction de l'état par l'intermédiaire du dispositif de commande.

8. Procédé d'affichage selon la revendication 7, **caractérisé en ce que** l'état comprend un état plié et un état aplati.

9. Procédé d'affichage selon la revendication 8, **caractérisé en ce que** la commande respective de l'affichage de la première partie (21), de la deuxième partie (22) et de la troisième partie (23) en fonction de l'état comprend les étapes consistant à
lorsque l'état est l'état plié, commander la première partie (21) et/ou la troisième partie (23) pour afficher et commander la deuxième partie (22) pour ne pas afficher : et
lorsque l'état est l'état aplati, commander la première partie (21), la deuxième partie (22) et la troisième partie (23) pour afficher simultanément.
